# EUROPÄISCHE PATENTSCHRIFT

(11) **EP 2 923 211 B1**
(45) Veröffentlichungstag und Bekanntmachung des Hinweises auf die Patenterteilung: **19.03.2025**
(21) Anmeldenummer: 13811135.6
(22) Anmeldetag: 21.11.2013
(51) Int. Cl.: G01R 1/067, G01R 31/28, G01R 1/073

(54) **VERFAHREN UND VORRICHTUNG ZUM PRÜFEN EINES WERKSTÜCKS**
METHOD AND DEVICE FOR TESTING A WORKPIECE
PROCÉDÉ ET DISPOSITIF DE CONTRÔLE D'UNE PIÈCE

(30) Priorität: 21.11.2012 DE 102012111215; 21.11.2012 DE 102012111216
(43) Veröffentlichungstag der Anmeldung: 30.09.2015
(73) Patentinhaber: KONRAD GmbH, 78315 Radolfzell (DE)
(72) Erfinder: KONRAD, Michael, 78315 Radolfzell (DE); WERNER, Stefan, 78315 Radolfzell (DE)
(74) Vertreter: Patentanwälte und Rechtsanwalt Weiß, Arat & Partner mbB
(86) Internationale Anmeldenummer: PCT/EP2013/074348
(87) Internationale Veröffentlichungsnummer: WO 2014/079913

(56) Entgegenhaltungen:
- EP-A1- 0 574 149
- WO-A2-2008/113372
- WO-A2-2012/075033
- DE-A1- 19 503 329
- DE-A1- 19 646 252
- DE-A1- 2 800 775
- DE-C1- 4 416 151
- FR-A1- 2 356 341
- US-A- 3 851 249
- US-A- 4 527 119
- US-A- 4 884 024
- US-A- 5 635 849
- US-A- 5 867 032
- US-A- 6 051 982
- US-A1- 2002 013 667
- US-A1- 2007 257 685
- US-A1- 2009 237 100
- US-A1- 2009 278 561
- US-A1- 2010 066 393
- US-B1- 7 091 730

## Beschreibung

Die Erfindung betrifft ein Verfahren und eine Vorrichtung zum Prüfen eines Werkstücks, insbesondere einer Leiterplatte, entsprechend dem Oberbegriff von Anspruch 1 bzw. 4, sowie eine Verwendung von einem intrinsisch aktiven Polymer nach Anspruch 9.

### Stand der Technik

In vielen Fällen des täglichen Lebens müssen Gegenstände bewegt werden. Nur beispielsweise wird nachfolgend auf elektronische Prüfvorrichtungen verwiesen. Darauf soll aber für die Erfindung nicht beschränkt sein. Die Beschreibung ist nur beispielhaft zu sehen. Ebenfalls nicht einschränkend bezieht sich die vorliegende Erfindung auf Bewegungen, die in Miniaturbereichen stattfinden. Hierfür ist sie besonders gut geeignet.

Derartige Prüfvorrichtungen sind in vielfältiger Form und Ausführung bekannt und auf dem Markt. Die vorliegende Erfindung bezieht sich auf jede Prüfvorrichtung, mit der ein Werkstück durch eine Mehrzahl von Prüfstiften abgetastet werden soll, die in einem bestimmten Verhältnis zueinander angeordnet sind, diese Anordnung aber ggf. geändert werden muss. Vor allem, aber nicht ausschliesslich bezieht sich die vorliegende Erfindung auf Prüfvorrichtungen zum Untersuchen von elektronischen Leiterplatten auf Fehler und Funktion vor dem Einbau in elektronische Geräte.

In solchen Vorrichtungen werden Kontaktstifte oder -nadeln an vorbestimmten Stellen (Kontaktpositionen) der Leiterplatte angedrückt und dann entsprechend einer vorbestimmten Steuerung durch einen Prüfcomputer mit Prüfsignalen beaufschlagt, um die Funktionstüchtigkeit der bestückten Leiterplatte zu ermitteln. Um einen einwandfreien, elektrischen Kontakt zwischen den Kontaktnadeln und Kontaktstellen auf einer Leiterplatte herzustellen, die eine grosse Anzahl von Kontaktpositionen abgreift, sind oftmals mehrere tausend Kontaktnadeln notwendig bzw. möglich.

Derartige Prüfeinrichtungen sind beispielsweise in der DE 11 2006 003 034 T5 oder auch der DE 196 46 252 A1 oder der DE 44 16 151 B beschrieben. All diese Geräte setzen aber voraus, dass die zu prüfenden Leiterplatten exakt den Prüfstiften zugeordnet werden. Da innerhalb einer Zeiteinheit auch eine Vielzahl derartiger Prüfungen stattfinden müssen, kommt es zu erheblichen Problemen bei der Positionierung der Leiterplatte im Verhältnis zu den Prüfstiften.

Ein häufig auftretendes Problem bei derartigen Prüfeinrichtung, insbesondere für Leiterplatten, ist, dass das zu prüfende Werkstück nachträglich abgeändert wird. Das bedeutet, dass auch der Prüfadapter mit den Prüfstiften nachträglich neu designed werden muss, was lange Zeit in Anspruch nimmt, da z.B. Anstellwinkel und Anordnung der Prüfstifte zueinander neu berechnet werden müssen und auch die entsprechenden Halterungen, z.B. Lochplatten, neu designed werden müssen.

Aus der US 5 635 849 A ist beispielsweise bekannt, dass eine Prüfspitze durch einen Aktuator bewegt wird. Dieser beinhaltet im wesentlichen eine Spule, die ein magnetisches Feld erzeugt und eine Deflektion der Prüfspitze bewirkt.

Aus der US 7 091 730 B1 ist ein Prüfstift bekannt, der mit zwei Spitzen versehen ist, wobei eine Prüfspitze exzentrisch zur ersten angeordnet ist. Bei Drehen des Prüfstifts dreht sich diese zweite Spitze um die erste Spitze.

Aus der US 2002/0013667 A1 ist eine elektrische Testeinrichtung für eine Leiterplatte bekannt, wobei eine Vielzahl von Prüfstiften vorgesehen sind, die auf elektromagnetischem Wege in allen drei Richtungen bewegt werden können.

Bei der DE 195 03 329 A1 sind entsprechende Prüfnadeln mit Schlitten gekoppelt, welche die Nadeln in X- und Y-Richtung schwenken können.

Aus der WO 2012 075033 A2 ist eine Strukturanordnung bekannt, welche Mikroaktuatoren aufweist. Diese sind eingebettet in ein Substrat, welches ein Hydrogelpolymer sein kann. Dieses Hydrogelpolymer soll auf Umwelteinflüsse reagieren. Infolge dieser Umwelteinflüsse bewegen sich die Mikroaktuatoren von einer ersten in eine zweite Position aufgrund von einem Volumenwechsel des Hydrogelpolymers.

Die WO 2008 113372 A2 zeigt eine Vorrichtung mit einem Aktuator aus einem elektroaktiven Polymer. Dabei weist die Vorrichtung zwei Teile auf, welche durch den Aktuator voneinander getrennt werden.

### Aufgabe

Aufgabe der vorliegenden Erfindung ist es, ein Verfahren und eine Vorrichtung der o.g. Art zu entwickeln, mit denen eine Änderung der Anordnung der Prüfstifte zueinander erleichtert und insbesondere beschleunigt wird. Aufgabe der vorliegenden Erfindung ist es auch, die Bewegung von Prüfstiften vor allem auf dem Gebiete der Elektronik aber auch der Mikromechanik zu verbessern.

### Lösung der Aufgabe

Zur Lösung der Aufgabe führen die Merkmale des Anspruchs 1, 4 bzw. 9.

Intrinsisch aktive Polymere sind Kunststoffe, welche bei Einwirken bestimmter physikalischer (z.B. Temperatur, Licht bestimmter Wellenlänge, elektrische und magnetische Feldgrössen) oder chemischer (Stoffkonzentrationen, pH-Wert) Umgebungsgrössen Materialeigenschaften definiert ändern. Vor allem sind dies phasenreversible Polymere (z.B. stimuli-sensitive Hydrogele, Polymerbürsten) phasenveränderliche Polymere, leitfähige Polymere sowie bi-lektrische Elastomere. Weitere Vertreter der intrinsisch aktiven Polymere sind Formgedächtnispolymere, piezoelektrische Polymere, elektrostrikitve Polymere sowie ferroelektrische Polymere.

Die vorliegende Erfindung verwendet vor allem elektroaktive oder sogenannte stimuli-sensitive Hydrogele. Diese Materialien sind Festkörpereffektträger mit der grössten aktorisch nutzbaren Volumenänderung und deshalb ausserordentlich gut miniaturisierbar.

Als Basis wird das temperatursensitive Poly-(N-Isopropylacrylamid) (PNIPAAm) genutzt.

In einem ersten Schritt gemäss der vorliegenden Erfindung werden die mechanischen und aktorischen Eigenschaften des Aktormaterials auf spezifizierte Antriebsaufgaben zugeschnitten. Die zu erwartenden mechanischen Beanspruchungen werden die erreichbaren Eigenschaften des Homopolymers PNIPAAm übersteigen. Deshalb wird das Polymer mit speziellen Nanomaterialien aus der Gruppe der Schichtsilikate funktionalisiert, was zu einer Verbesserung der mechanisch-aktorischen Hydrogeleigenschaften um mehr als eine Grössenordnung führt. Die Parameteroptimierung des aktiven Polymers erfolgt durch Variation der Vernetzungsbedingungen und spezifische Modifikation der Ausgangsstoffe, des Vernetzungsgrades und der Porosität der Vernetzungspunkte.

Des weiteren wurde die Steuerbarkeit der Aktormaterialien optimiert. Im unmodifizierten Zustand lassen sich die Hydrogelaktoren im Bereich ihres Volumenphasenübergangs durch Variation der Aktortemperatur um lediglich 5 K vom vollständig gequollenen zum völlig entquollenen Zustand schalten. Um die Aktorsteuerung hochpräzise durchzuführen, kann der Bedarf entstehen, den Volumenphasenübergangsbereich z.B. auf 10 K aufzuweiten. Dies ist einerseits durch Co-Polymerisation des N-Isopropylacrylamids, andererseits aber auch durch die Variation der thermodynamischen Qualität des Lösungsmittels erreichbar.

Darüber hinaus sollte das Aktormaterial mikrostrukturierbar sein. Dafür wird erfindungsgemäss eine radikalische Photopolymerisation verwendet, mit der das Hydrogel nicht nur synthetisiert, sondern auch formgebend mikrostrukturiert wird.

Ein weiterer Aspekt ist die Integrationsfähigkeit des Aktormaterials in ein übergeordnetes System. Hier sind einerseits die erforderlichen Materialkompatibilitäten zu gewährleisten, andererseits für die kovalente Haftung geeignete Haftvermittlersysteme zu finden.

Eine Vorrichtung bzw. ein Positionierantrieb zur Durchführung des Verfahrens ist als kompaktes, voll integriertes System konzipiert und umfasst folgende Baugruppen:
(i) zumindest ein Aktor,
(ii) Aktor-Steuerelektroden,
(iii) einen Arretiermechanismus,
(iv) ein Antriebsgehäuse inklusive mechanische Schnittstellen,
(v) zumindest eine Schnittstellen zu übergeordneten Systemen und
(vi) eine hard- und softwarebasierte Steuerung des Positionierantriebs.

Im Rahmen der vorliegenden Erfindung liegt vor allem, diese Polymere im Siebdruckverfahren auf eine Halterung aufzubringen, damit sie dort die entsprechenden Prüfstifte umgeben können. Werden sie dann mit einer entsprechenden physikalischen oder chemischen Umgebungsgrösse konfrontiert bzw. beaufschlagt, ändern sie definiert Ihre Lage wie ein Muskel und bewegen dabei den Prüfstift.

Insgesamt ist natürlich daran gedacht, die Änderungen der Prüfstifte genauestens zu beobachten. Dies geschieht durch entsprechende Kameras, wobei im Rahmen der vorliegenden Erfindung vor allem daran gedacht ist, dass der Prüfstift direkt durch ein Objektiv der Kamera hindurchgeführt ist, so dass diese Kamera genauestens die Bewegung des Prüfstiftes beobachten kann.

### Figurenbeschreibung

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
**Figur 1** eine schematische Seitenansicht auf einen Teil einer Vorrichtung zum Prüfen eines Werkstücks;
**Figur 2 - 5** schematische Seitenansichten von weiteren Ausführungsbeispielen von Vorrichtungen zum Prüfen von Werkstücks;
**Figur 6** eine schematische Seitenansicht einer Anordnung zum Beobachten von Prüfstiften;
**Figur 7** eine schematische Seitenansicht einer weiteren Anordnung zum Überwachen der Tätigkeit von Prüfstiften;
**Figur 8** eine schematisch dargestellte Seitenansicht eines weiteren Ausführungsbeispiels eines Teils einer Vorrichtung zum Prüfen eines Werkstücks;
**Figur 9** eine Draufsicht auf eine Halterung für Prüfstifte;
**Figur 10 und 11** eine schematisch dargestellte Draufsicht und Seitenansicht auf einen Ausschnitt von Figur 9 mit elektroaktiven Polymeraktivatoren;
**Figur 12** eine perspektivisch dargestellte Draufsicht auf einen prinzipiellen Aufbau eines mehraxialen Positionierantriebs;
**Figur 13** eine perspektivisch dargestellte Seitenansicht eines erfindungsgemässen Kontaktnadelkopfes;
**Figur 14** eine perspektivische Ansicht eines Kontaktnadelkopfes;
**Figur 15** eine perspektivische Ansicht eines mehraxialen Positionierantriebs mit Kontaktnadel.

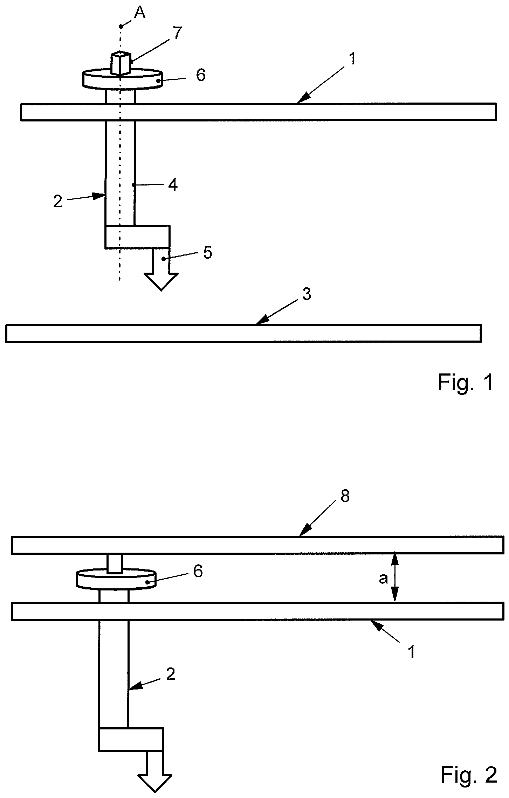

Gemäss Figur 1 befindet sich an einer Halterung 1 ein Prüfstift 2, wobei natürlich davon auszugehen ist, dass an dieser Halterung 1 in der Regel eine Vielzahl derartiger Prüfstifte 2 vorgesehen ist. Mit diesem Prüfstift 2 soll eine Leiterplatte 3 geprüft werden.

Der Prüfstift 2 durchsetzt mit einem Schaft 4 die Halterung 1, die als Lochplatte ausgebildet ist. Dieser Schaft 4 ist in einer entsprechenden Ausnehmung in der Lochplatte 1 drehbar um eine Achse A angeordnet. Zu dieser Achse A exzentrisch befindet sich eine Prüfspitze 5, die bei Drehung des Schaftes 4 in ihrer Lage gegenüber dem Werkstück (Leiterplatte 3) verändert werden kann. Selbstverständlich ist es zusätzlich möglich, auch die Ausnehmung in der Lochplatte 1, welche von dem Schaft 4 durchsetzt wird, entsprechend auszubilden, so dass zusätzlich die Lage der Prüfspitze 5 verändert werden kann. Beispielsweise könnte die Ausnehmung ein Langloch od. dgl. sein.

Zur Fixierung des Prüfstifts 2 gegenüber der Lochplatte 1 ist ein Magnet 6 auf dem Schaft 4 vorgesehen. In diesem Fall ist bevorzugt die Lochplatte 1 zumindest teilweise magnetisch ausgebildet, so dass zwischen dem Magnet 6 und der Lochplatte 1, wie durch die Pfeile angedeutet, eine Anziehungskraft wirkt.

Es geschieht das Drehen des Schaftes 4 durch einen nicht näher gezeigten Schlüssel, der auf einen Justage-Hilfsvierkant 7 aufgesetzt werden kann. Wird somit eine andere Lage der Prüfspitze 5 gegenüber der Leiterplatte 3 gewünscht, so kann durch den Schlüssel der Prüfstift 2 um seine Achse A gedreht und die Prüfspitze 5 kreisförmig bewegt werden. Gleichzeitig bzw. zusätzlich ist auch daran gedacht, entweder die Lochplatte 1 und/oder die Leiterplatte 3 in der Waagrechten zweidimensional zu bewegen, so dass dadurch jeder Punkt auf der Leiterplatte 3 mit der Prüfspitze 5 angefahren werden kann. Ein derartiger Bewegungsmechanismus für die Leiterplatte 3 ist beispielsweise in der DE 10 2012 106 291.9 gezeigt.

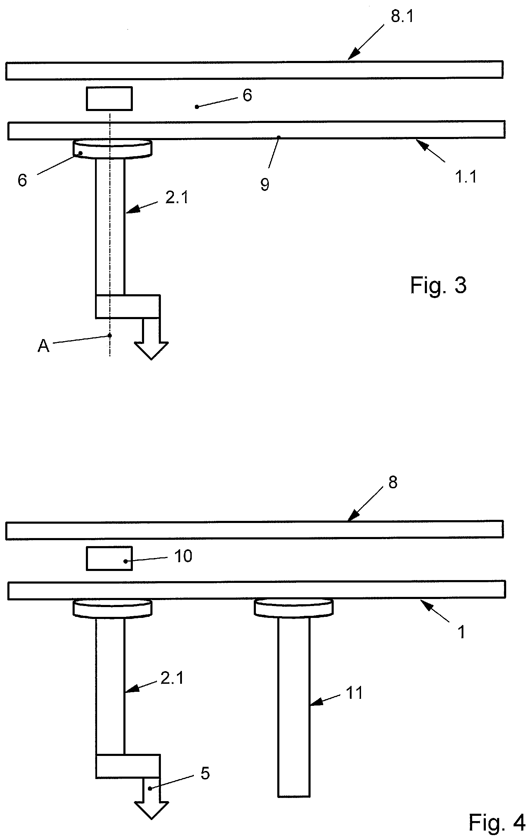

Bei der Vorrichtung zum Prüfen eines Werkstücks gemäss Figur 3 ist der Lochplatte 1 zusätzlich eine Fixierplatte 8 zugeordnet, wobei ein Abstand a zwischen Lochplatte 1 und Fixierplatte 8 veränderbar ist. Diese Fixierplatte 8 hat u.a. die Aufgabe, nach der Einstellung der einzelnen Prüfstifte 2, diese gegenüber der Lochplatte 1 festzulegen, d.h., sie unterstützt im wesentlichen den Magnet 6, damit die Prüfstifte 2 beim Absenken auf die Leiterplatte 3 nicht von der Lochplatte 1 abgehoben werden und die Lage der Prüfstifte 2 versehentlich verändert wird.

In der Vorrichtung zum Prüfen von Werkstücken gemäss Figur 3 wird als Halterung 1.1 nicht eine Lochplatte sondern eine halbmagnetische Platte verwendet. Das bedeutet, dass die grundsätzliche Position der Prüfstifte 2.1 in diesem Fall nicht vom Lochraster einer Lochplatte abhängt, sondern der Prüfstift 2.1 frei entlang einer Unterseite 9 der Halterung 1.1 bewegt werden kann.

Eine Drehung des Prüfstiftes 2.1 um seine Achse A wird durch einen Antriebsmagnet 10 bewirkt, der jenseits vom Prüfstift 2.1 der Halterung 1.1 zugeordnet ist. Dieser Antriebsmagnet 10 kann entlang der Halterung 1.1 in beliebiger Richtung bewegt, aber auch gedreht werden, so dass ihm der Magnet 6 folgt und so eine Ausrichtung des Prüfstifts 2.1 gegenüber einer nicht gezeigten Leiterplatte erfolgen kann.

Oberhalb des Antriebsmagnets 10 ist noch eine magnetisch leitende Fixierplatte 8.1 vorgesehen, mit der die gesamte Anordnung festgelegt werden kann.

Die Vorrichtung zum Prüfen eines Werkstücks gemäss Figur 4 unterscheidet sich von derjenigen nach Figur 3 nur durch die Anordnung eines zusätzlichen Werkzeugs 11, mit dem eine weitere Tätigkeit vorgenommen werden kann. Beispielsweise kann es sich dabei um einen gefederten Niederhalter handeln, der auf das Werkstück drückt oder aber auch um eine Kamera, welche die Prüfspitze 5 beobachtet.

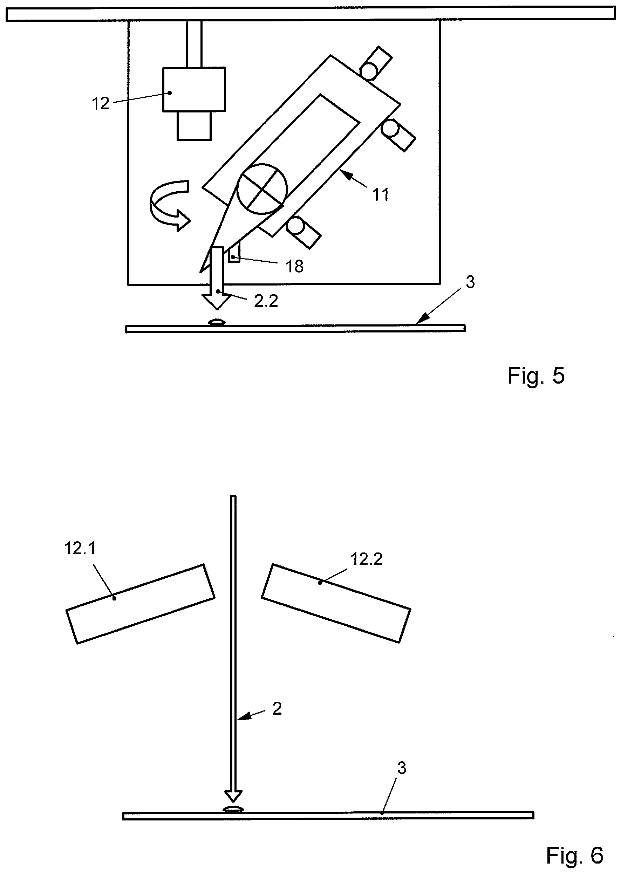

Bei der Vorrichtung zum Prüfen eines Werkstücks 3 gemäss Figur 5 befindet sich der Prüfstift 2.2 an einem Schlitten 11, der in beliebiger Weise bewegt werden kann. Nur beispielsweise wird hier wiederum auf die DE 10 2012 106 291.9 verwiesen. Die Bewegung des Schlittens 11 bzw. die Lage des Prüfstifts 2.2 gegenüber der Leiterplatte 3 kann durch eine separate Kamera 12 und/oder auch durch eine dem Schlitten 11 zugeordnete Kamera 13 beobachtet und kontrolliert werden.

In Figur 6 ist angedeutet, dass die Tätigkeit des Prüfstifts 2 durch zwei schräggestellte Kameras 12.1 und 12.2 beobachtet wird.

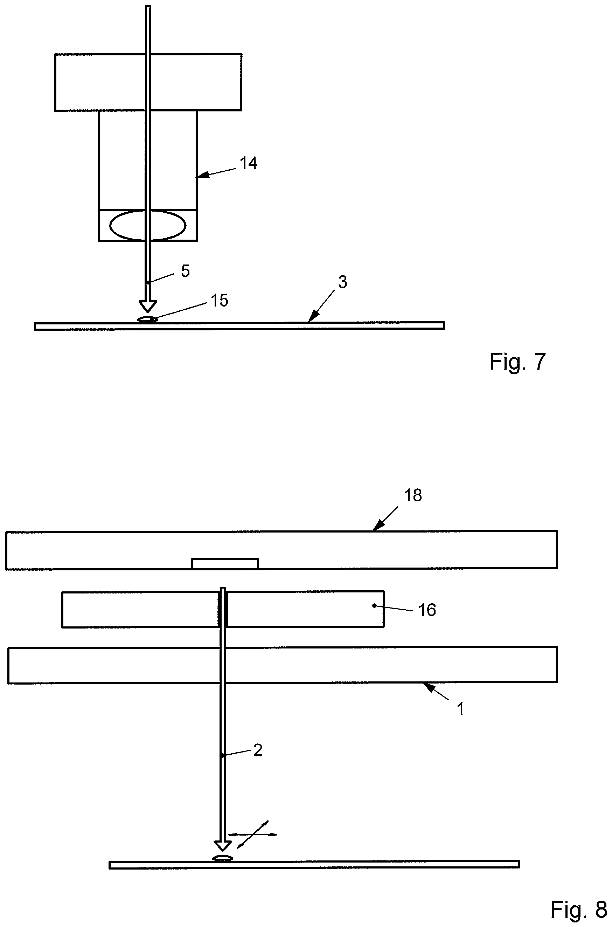

In Figur 7 durchsetzt der Prüfstift 2 bzw. eine Prüfspitze 5 das Objektiv 14 einer Kamera direkt, so dass dieses Objektiv 14 direkt auf einen Auftreffpunkt 15 der Prüfspitze 5 auf der Leiterplatte 3 ausgerichtet ist.

Eine Ausführungsform der vorliegenden Erfindung wird in den Figuren 8 bis 13 aufgezeigt. Dabei handelt es sich um die Möglichkeit der Bewegung eines Prüfstiftes 2 mittels elektroaktiver Polymere 16, die als Aktuatoren für den Prüfstift 2 wirken.

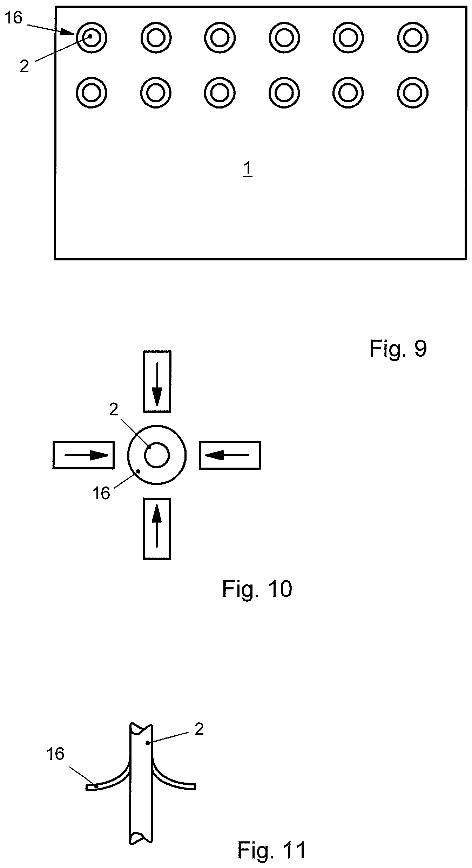

In den Figuren 9 bis 13 wird eine weitere Möglichkeit der Bewegung der Prüfstifte 2 aufgezeigt, die durch sogenannte intrinsisch aktive Polymere bewirkt wird. Sie bewegen sich muskelähnlich. Für den vorliegenden Erfindungsgedanken werden vor allem elektroaktive Polymere (EAP) bevorzugt, da mittels einer elektrischen Feldgrösse das Polymer direkt und gezielt beeinflusst werden kann.

Gemäss Figur 9 wird ein entsprechender Prüfstift 2 in einer Lochplatte 1 geführt. Auf bzw. über der Lochplatte 1 befinden EAP-Aktuatoren 16.1 und 16.2, welche den Prüfstift 2 angreifen. Schematisch ist dies vor allem in den Figuren 10 und 11 dargestellt. Der entsprechende EAP-Aktuator umgibt den Prüfstift 2, wobei der EAP-Aktuator 16 selbst gemäss Figur 10 von vier Seiten her mit einer elektrischen Feldgrösse beaufschlagt wird. Diese bewirkt beispielsweise gemäss Figur 11, dass sich ein mittlerer Bereich des EAP-Aktuators aufwölbt und dabei den Prüfstift 2 anhebt. Durch entsprechende Beaufschlagung des EAP-Aktuators mit der elektrischen Feldgrösse kann auch eine Drehung des Prüfstifts 2 bewirkt werden.

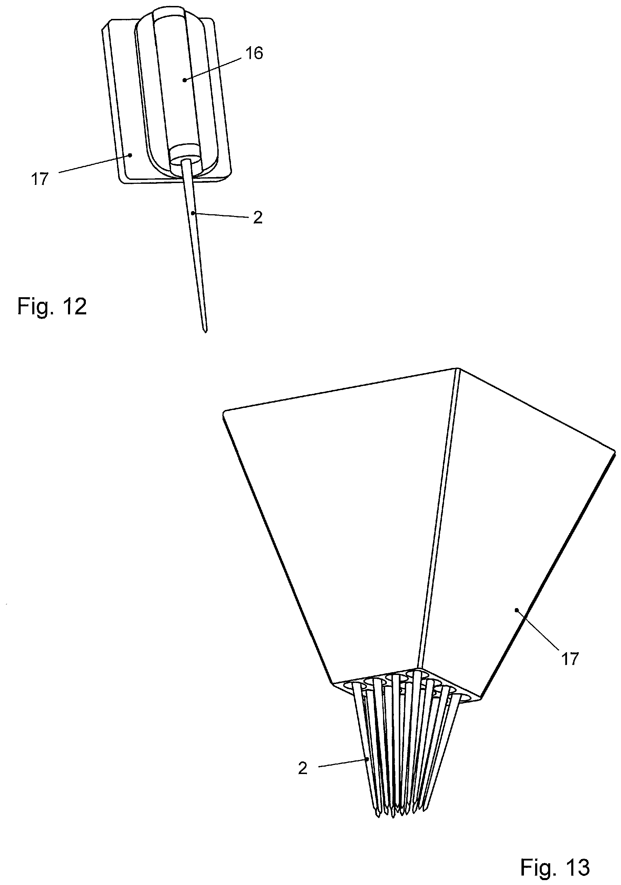

In den Figuren 12 und 13 ist dargestellt, wie ein entsprechender Prüfstift 2 in ein Gehäuse 17 integriert ist, wobei der Prüfstift 2 im oberen Bereich bzw. innerhalb des Gehäuses 17 von einem EAP-Aktuator 16 umgeben ist.

Dabei ragen aus dem Gehäuse 17 eine Mehrzahl von Prüfstiften 2 heraus. Diese Kontaktnadeln oder Prüfstifte 2 sind von einem Polymerreaktor 16 umfangen, der in das Gehäuse 17 eingebettet ist.

Dieser hydrogelbasierte Aktor besitzt die Aufgabe, die Kontaktnadel mit einer Positioniergenauigkeit von ca. 25 µm frei in der x-y-Ebene bei maximalen Positionierwegen von +/- 500 µm ausgehend von der Normalposition zu stellen. Diese komplizierte mehraxiale Positionierung lässt sich mit einem flexiblen Festkörperreaktor realisieren, der sich bei entsprechender Ansteuerung in analoger Weise so deformiert, dass er über die Kontaktnadel jeden beliebigen Punkt in der Positionierebene anfahren kann. Dies erfordert das Finden einer geeigneten konstruktiven Gestaltung und Dimensionierung. Die erreichbare Positioniergenauigkeit wird darüber hinaus von der Leistungsfähigkeit der Aktor-Steuerelektroden bestimmt. Die resistiven Steuerelektroden sind segmentiert und realisieren ein Steuern des Temperaturfelds, welches elektronisch um 360° drehbar ist. Wesentliche Untersuchungskriterien sind die notwendige Elektrodenanzahl, um die Kontaktnadeln hinreichend genau positionieren zu können, die benötigte Heizleistung, der Verlauf des Wärmefeldes, die Wärmeeinkopplung und das Wärmemanagement zum Stabilisieren des steuernden Temperaturfeldes.

Der Kontaktnadel-Positionierantrieb ist nur für den eigentlichen Positioniervorgang zuständig. Sollte die Kontaktnadel ihre Endposition erreicht haben, wird ein Arretiermechanismus aktiviert, welcher die Nadeln in ihrer Position fixieren.

Während der Nadelpositionierung ist sicherzustellen, dass der Kopf im Bereich der Positionierantriebe eine gleichbleibende, definierte Temperatur aufweist, um die Unabhängigkeit der Positioniervorgänge von eventuellen Schwankungen der Umgebungstemperatur zu gewährleisten. Das aktive Temperaturmanagement lässt sich z.B. durch Peltierelemente oder eine aktive Wasserkühlung realisieren.

Das Antriebsgehäuse sorgt nicht nur für den mechanischen Schutz des Positionierantriebs, sondern trägt auch dessen mechanische und elektrische Schnittstellen.

Der Kopf muss zudem über Justagemöglichkeiten verfügen, um ihn optimal einstellen bzw. vorpositionieren zu können. Für die Positionierantriebe lässt sich im Idealfall eine globale Justage realisieren, alternativ werden Konzepte der Einzeljustage untersucht.

Für den Arretiermechanismus scheinen vor allem kraftschlüssige Prinzipien geeignet.

### Bezugszeichenliste

| | | | | | |
|---|---|---|---|---|---|
| 1 | Halterung | 34 | | 67 | |
| 2 | Prüfstift | 35 | | 68 | |
| 3 | Leiterplatte | 36 | | 69 | |
| 4 | Schaft | 37 | | 70 | |
| 5 | Prüfspitze | 38 | | 71 | |
| 6 | Magnet | 39 | | 72 | |
| 7 | Hilfsvierkant | 40 | | 73 | |
| 8 | Fixierplatte | 41 | | 74 | |
| 9 | Unterseite | 42 | | 75 | |
| 10 | Antriebsmagnet | 43 | | 76 | |
| 11 | Schlitten | 44 | | 77 | |
| 12 | Kamera | 45 | | 78 | |
| 13 | Kamera | 46 | | 79 | |
| 14 | Objektiv | 47 | | | |
| 15 | Auftreffpunkt | 48 | | | |
| 16 | EAP-Aktuator | 49 | | | |
| 17 | Gehäuse | 50 | | | |
| 18 | PCB-Platte | 51 | | | |
| 19 | Werkzeug | 52 | | A | Achse |
| 20 | | 53 | | | |
| 21 | | 54 | | a | Abstand |
| 22 | | 55 | | | |
| 23 | | 56 | | | |
| 24 | | 57 | | | |
| 25 | | 58 | | | |
| 26 | | 59 | | | |
| 27 | | 60 | | | |
| 28 | | 61 | | | |
| 29 | | 62 | | | |
| 30 | | 63 | | | |
| 31 | | 64 | | | |
| 32 | | 65 | | | |
| 33 | | 66 | | | |
| | | | | | |

## Patentansprüche

1. Verfahren zum Prüfen eines Werkstücks (3), insbesondere einer Leiterplatte, mittels einem mit einem Schaft (4) eine Halterung (1) durchsetzenden Prüfstift (2), der eine vorbestimmte Position auf oder in dem Werkstück (3) anfährt, wobei eine Lage des Prüfstifts (2) gegenüber der Halterung (1) verändert wird,
**dadurch gekennzeichnet,**
**dass** eine Veränderung der Lage des Prüfstifts (2) gegenüber der Halterung (1) durch ein intrinsisch aktives Polymer erfolgt, das den Schaft (4) des Prüfstifts (2) zumindest teilweise umfängt, wobei die intrinsisch aktiven Polymere im Siebdruckverfahren auf die Halterung (1) aufgebracht werden.

2. Verfahren nach Anspruch 1, **dadurch gekennzeichnet, dass** die Veränderung der Lage des Prüfstifts (2) beobachtet wird.

3. Verfahren nach Anspruch 2, **dadurch gekennzeichnet, dass** die Veränderung der Lage des Prüfstifts (2) dadurch beobachtet wird, dass der Prüfstift (2) durch das Objektiv (14) einer Kamera geführt wird.

4. Vorrichtung zum Prüfen eines Werkstücks (3), insbesondere einer Leiterplatte, mittels einem mit einem Schaft (4) eine Halterung (1) durchsetzenden Prüfstift (2), der eine vorbestimmte Position auf oder in dem Werkstück (3) anfährt, wobei eine Lage des Prüfstifts (2) gegenüber der Halterung (1) veränderbar ist, **dadurch gekennzeichnet, dass** dem Prüfstift (2) ein intrinsisch aktives Polymer (16) zugeordnet ist, das dazu ausgebildet ist, die Lage des Prüfstifts (2) gegenüber der Halterung (1) zu verändern, und welches den Schaft (4) des Prüfstifts (2) zumindest teilweise umfängt, wobei das intrinsisch aktive Polymere (16) im Siebdruckverfahren auf die Halterung (1) aufgebracht ist.

5. Vorrichtung nach Anspruch 4, **dadurch gekennzeichnet, dass** das intrinsisch aktive Polymer (16) ein elektroaktives Polymer ist.

6. Vorrichtung nach Anspruch 5, **dadurch gekennzeichnet, dass** das Polymer von vier Seiten her mit einer elektrischen Feldgröße beaufschlagt wird.

7. Vorrichtung nach Anspruch 4, **dadurch gekennzeichnet, dass** das Polymer (16) ein stimuli-sensitives Hydrogel ist.

8. Vorrichtung nach Anspruch 7, **dadurch gekennzeichnet, dass** das intrinsisch aktive Polymer (16) ein temperatursensitives Poly(*N*-Isopropylacrylamid) (PNIPAAm) ist.

9. Verwendung von einem intrinsisch aktiven Polymer (16) zur Bewegung von Prüfstiften (2), die mit einem Schaft (4) eine Halterung (1) durchsetzen und der Prüfung von Werkstücken (3), insbesondere von Leiterplatten dienen, wobei die Prüfstifte (2) eine vorbestimmte Position auf oder in dem Werkstück (3) anfahren, wobei eine Veränderung der Lage jedes Prüfstifts (2) gegenüber der Halterung (1) durch das intrinsisch aktives Polymer erfolgt, wobei das intrinsisch aktive Polymer (16) den Schaft (4) des Prüfstifts (2) zumindest teilweise umfängt, wobei das intrinsisch aktive Polymere (16) im Siebdruckverfahren auf die Halterung (1) aufgebracht ist.

## Claims

1. Method for testing a workpiece (3), in particular a printed circuit board, by means of a testing pin (2) which passes through a holder (1) with a shaft (4) and which approaches a predetermined position on or in the workpiece (3), a position of the testing pin (2) being changed relative to the holder (1),
**characterized in that**
**in that** a change in the position of the testing pin (2) relative to the holder (1) is effected by an intrinsically active polymer which at least partially surrounds the shaft (4) of the testing pin (2), the intrinsically active polymers being applied to the holder (1) by screen printing.

2. Method according to claim 1, **characterized in that** the change in the position of the test pin (2) is observed.

3. Method according to claim 2, **characterized in that** the change in the position of the testing pin (2) is observed by guiding the testing pin (2) through the lens (14) of a camera.

4. Device for testing a workpiece (3), in particular a printed circuit board, by means of a testing pin (2) which passes through a holder (1) with a shaft (4) and which approaches a predetermined position on or in the workpiece (3), the position of the testing pin (2) being changed relative to the holder (1), **characterized in that** the testing pin (2) is assigned an intrinsically active polymer (16) which is designed to change the position of the testing pin (2) relative to the holder (1), and which at least partially surrounds the shaft (4) of the testing pin (2), the intrinsically active polymer (16) being applied to the holder (1) by screen printing.

5. Device according to claim 4, **characterized in that** the intrinsically active polymer (16) is an electroactive polymer.

6. Device according to claim 5, **characterized in that** the polymer is subjected to an electric field from four sides.

7. Device according to claim 4, **characterized in that** the polymer (16) is a stimuli-sensitive hydrogel.

8. Device according to claim 7, **characterized in that** the intrinsically active polymer (16) is a temperature-sensitive Poly(N-isopropylacrylamide) (PNIPAAm).

9. Use of an intrinsically active polymer (16) for moving testing pins (2) which pass through a holder (1) with a shaft (4) and serve to test workpieces (3), in particular printed circuit boards, the testing pins (2) travelling to a predetermined position on or in the workpiece (3), wherein the change in the position of each testing pin (2) relative to the holder (19) is effected by the intrinsically active polymer, wherein the intrinsically active polymer (16) at least partially surrounds the shaft (4) of the testing pin (2), wherein the intrinsically active polymer (16) is applied to the holder (1) by screen printing.

## Revendications

1. Procédé permettant le contrôle d'une pièce (3), en particulier d'une carte de circuits imprimés, au moyen d'une broche de contrôle (2) traversant un dispositif de maintien (1) avec une tige (4), laquelle broche de contrôle se déplace vers une position prédéterminée sur ou dans la pièce (3), dans lequel un emplacement de la broche de contrôle (2) est modifié par rapport au dispositif de maintien (1),
caractérisé en ce
**qu**'une modification de l'emplacement de la broche de contrôle (2) par rapport au dispositif de maintien (1) est effectuée par un polymère intrinsèquement actif qui entoure au moins partiellement la tige (4) de la broche de contrôle (2), dans lequel les polymères intrinsèquement actifs sont appliqués sur le dispositif de maintien (1) par procédé de sérigraphie.

2. Procédé selon la revendication 1, **caractérisé en ce que** la modification de l'emplacement de la broche de contrôle (2) est surveillée.

3. Procédé selon la revendication 2, **caractérisé en ce que** la modification de l'emplacement de la broche de contrôle (2) est surveillée en faisant passer la broche de contrôle (2) à travers l'objectif (14) d'une caméra.

4. Dispositif permettant le contrôle d'une pièce (3), en particulier d'une carte de circuits imprimés, au moyen d'une broche de contrôle (2) traversant un dispositif de maintien (1) avec une tige (4), laquelle broche de contrôle se déplace vers une position prédéterminée sur ou dans la pièce (3), dans lequel un emplacement de la broche de contrôle (2) par rapport au dispositif de maintien (1) peut être modifié, **caractérisé en ce qu'**un polymère intrinsèquement actif (16) est associé à la broche de contrôle (2), lequel est conçu pour modifier l'emplacement de la broche de contrôle (2) par rapport au dispositif de maintien (1) et qui entoure au moins partiellement la tige (4) de la broche de contrôle (2), dans lequel le polymère intrinsèquement actif (16) est appliqué sur le dispositif de maintien (1) par procédé de sérigraphie.

5. Dispositif selon la revendication 4, **caractérisé en ce que** le polymère intrinsèquement actif (16) est un polymère électroactif.

6. Dispositif selon la revendication 5, **caractérisé en ce que** le polymère est soumis à une grandeur de champ électrique depuis quatre côtés.

7. Dispositif selon la revendication 4, **caractérisé en ce que** le polymère (16) est un hydrogel stimuli-sensible.

8. Dispositif selon la revendication 7, **caractérisé en ce que** le polymère intrinsèquement actif (16) est un poly(N-isopropylacrylamide) (PNIPAAm) sensible à la température.

9. Utilisation d'un polymère intrinsèquement actif (16) pour le déplacement de broches de contrôle (2) qui traversent un dispositif de maintien (1) avec une tige (4) et servent au contrôle de pièces (3), en particulier de cartes de circuits imprimés, dans laquelle les broches de contrôle (2) se déplacent vers une position prédéterminée sur ou dans la pièce (3), dans laquelle une modification de l'emplacement de chaque broche de contrôle (2) par rapport au dispositif de maintien (1) est effectuée par le polymère intrinsèquement actif, dans laquelle le polymère intrinsèquement actif (16) entoure au moins partiellement la tige (4) de la broche de contrôle (2), dans laquelle le polymère intrinsèquement actif (16) est appliqué sur le dispositif de maintien (1) par procédé de sérigraphie.
